# EUROPEAN PATENT SPECIFICATION

(11) **EP 3 050 116 B1**
(45) Date of publication and mention of the grant of the patent: **27.02.2019**
(21) Application number: 13894803.9
(22) Date of filing: 27.09.2013
(51) Int. Cl.: H01L 29/84

(54) **AN IMPROVED ARRANGEMENT OF THROUGH-HOLE STRUCTURES OF A SEMICONDUCTOR PACKAGE**
VERBESSERTE ANORDNUNG VON DURCHGANGSLOCHSTRUKTUREN EINES HALBLEITERPAKETS
AGENCEMENT AMÉLIORÉ DE STRUCTURES DE TROUS TRAVERSANTS D'UN BOÎTIER DE SEMI-CONDUCTEUR

(43) Date of publication of application: 03.08.2016
(73) Proprietor: Intel Corporation, Santa Clara, CA 95054 (US)
(72) Inventor: TEH, Weng Hong, Cambridge, MA 02139 (US); HANEY, Sarah K., Cary, NC 27518 (US); LIM, Chyi Hwang, Chandler, AZ 85248 (US)
(74) Representative: Rummler, Felix
(86) International application number: PCT/US2013/062457
(87) International publication number: WO 2015/047346

(56) References cited:
- WO-A1-2013/101156
- JP-A- 2010 000 556
- US-A1- 2005 229 704
- US-A1- 2008 079 142
- US-A1- 2008 138 922
- US-A1- 2010 162 821
- US-A1- 2011 318 861

## Description

### BACKGROUND

### 1. Technical Field

Embodiments of the invention are in the field of semiconductor packages and in particular, to semiconductor packages with microelectromechanical system (MEMS) structures.

### 2. Background Art

Today's consumer electronics market frequently demands complex functions requiring very intricate circuitry. Scaling to smaller and smaller fundamental building blocks, e.g. transistors, has enabled the incorporation of even more intricate circuitry on a single die with each progressive generation. Semiconductor packages are used for protecting an integrated circuit (IC) chip or die, and also to provide the die with an electrical interface to external circuitry. With the increasing demand for smaller electronic devices, semiconductor packages are designed to be even more compact and must support larger circuit density.

Furthermore, for the past several years, microelectromechanical systems (MEMS) structures have been playing an increasingly important role in consumer products. For example, MEMS devices, such as sensors, actuators, and mirrors, can be found in products ranging from air-bag triggers in vehicles to displays in the visual arts industry. As these technologies mature, the demands on precision and functionality of such MEMS structures have escalated. Furthermore, consistency requirements for the performance of MEMS devices (both intra-device and device-to-device) often dictates that the processes used to fabricate such MEMS devices need to be extremely sophisticated.

Although packaging scaling is typically viewed as a reduction in size, the addition of functionality in a given space is also considered. However, structural issues may arise when attempting to package semiconductor die with additional functionality also housed in the package. For example, the addition of packaged MEMS devices may add functionality, but ever decreasing space availability in a semiconductor package may provide obstacles to adding such functionality.

In the pursuit of substrate packaging build-up technology to build monolithic MEMS as part of the package, a particular challenge is the ability to isotropically etch out an underlying sacrificial material using patterned release holes in the active MEMS element. This is because, unlike silicon MEMS, the physical dimensions in packaging build-up MEMS devices are significantly larger, both in terms of the active MEMS devices and the dimensions of the sacrificial layers. These larger dimensions tend to correspond to a substantial reduction in the margin of release etch processing. Furthermore, the difficulty of release etch processing is typically exacerbated by the presence of fillers interspersed in the dielectric materials of some commercial film products.

Prior art showing how the arrangement of patterned release holes in a MEMS active element may by varied to improve the sacrificial layer etching efficiency include US 2005/0229704 A1 and US 2010/0162821 A1.

### SUMMARY OF THE INVENTION

A semiconductor package according to the invention is defined in claim 1. A method according to the invention is defined in claim 2.

### BRIEF DESCRIPTION OF THE DRAWINGS

The various embodiments are illustrated by way of example, and not by way of limitation, in the figures of the accompanying drawings and in which:
FIGs. 1A-1H illustrate cross-sectional views of various operations of a process to fabricate a packaged MEMS device according to an embodiment of the prior art.
FIG. 2 is an orthographic view illustrating elements of a MEMS device including an arrangement of through-hole structures according to an embodiment of the prior art.
FIG. 3 is a layout diagram illustrating a conventional arrangement of through-hole structures.
FIGs. 4A-4F are layout diagrams illustrating respective arrangements of through-hole structures according to various examples and embodiments. Figure 4B and 4C illustrate embodiments according to the present invention.
FIG. 5 is a flow diagram illustrating elements of a method for fabricating a semiconductor package according to an example.
FIG. 6 is a schematic of a computer system, in accordance with one example.

### DETAILED DESCRIPTION

Embodiments discussed herein variously provide for a first surface in a semiconductor package to include an improved arrangement of through-hole structures. The through-hole structures may provide for improved etching to form an air gap which separates a suspended portion of a MEMS device from a layer which underlies, or is otherwise proximate to, the suspended portion. In an embodiment, the first surface includes a plurality of edges each defining in part a respective through-hole of a plurality of through-holes extending between the first surface and a second surface of the structure. The first surface may comprise a plurality of arm portions each located between a respective pair of edge-adjacent edges of the plurality of edges. The first surface may further comprise a plurality of node portions each located at a respective junction of three or more of the plurality of arm portions. For each of the node portions, a respective total number of arm portions which join one another at the node portion may be a number other than four. Alternatively or in addition, for each of the node portions, two arm portions which join one another at the node portion may have respective mid-lines which are oblique to one another.

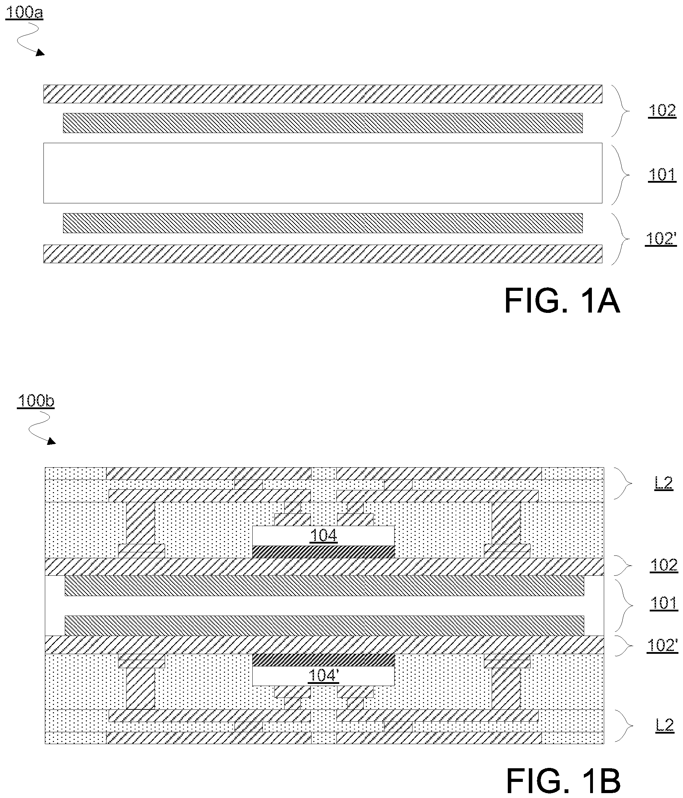

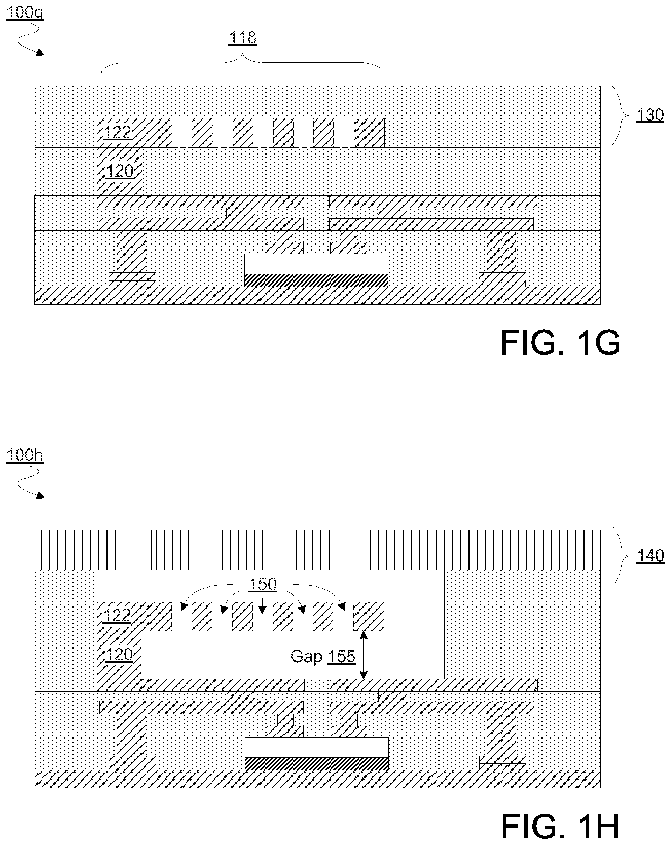

A packaged MEMS device may be housed in any of a variety of packaging options according to different embodiments. One such option is housing in a substrate formed by a BBUL process. For example, FIGs. 1A-1H illustrate cross-sectional views of various operations in a process of fabricating a packaged MEMS device having a suspended beam structure, in accordance with an illustrative embodiment.

Referring to FIG. 1A, a simplified view 100a of a carrier 101 including two panel sides 102 and 102' is depicted. A fully embedded process may be performed to package die 104/104' on either panel 102/102', respectively. As an example, FIG. 1B depicts a view 100b of a BBUL fully embedded die process up to level 2 (L2) metal layer definition. BBUL is a processor packaging technology that is bumpless since it does not use the usual small solder bumps to attach the silicon die to the processor package wires. It has build-up layers since it is grown or built-up around the silicon die. Although certain embodiments are not limited in this regard, some semiconductor packages now use a coreless substrate, which does not include the thick resin core layer commonly found in conventional substrates. In an embodiment, as part of the BBUL process, electrically conductive vias and routing layers are formed above the active side of the semiconductor die 104/104' using a semi-additive process (SAP) to complete remaining layers.

Thus, referring again to FIG. 1B, a semiconductor die may be packaged on a panel of a carrier. Carrier 101 may be provided having planar panels or panels with a plurality of cavities disposed therein, each sized to receive a semiconductor die 104/104'. Although certain embodiments are not limited in this regard, identical structures (e.g., 102 and 102') may be mated during processing in order to build a back-to-back apparatus for processing utility. Consequently, processing throughput is effectively doubled. The structure shown in FIG. 1B may form part of a larger carrier/panel structure with a plurality of identical regions having a similar or the same cross-section.

For example, a carrier may include panels with 1000 recesses on either side, allowing for fabrication of 2000 individual packages from a single carrier. The panel may include an adhesion release layer and an adhesive binder. A cutting zone may be provided at each end of the apparatus 102 or 102' for separation processing. A backside of a semiconductor die may be bonded to the panel with a die-bonding film. Encapsulating layers may be formed by a lamination process. In another embodiment, one or more encapsulation layers may be formed by spinning on and curing a dielectric upon a wafer-scale array of apparatuses, of which the apparatus 102/102' is merely a subset for illustrative simplicity.

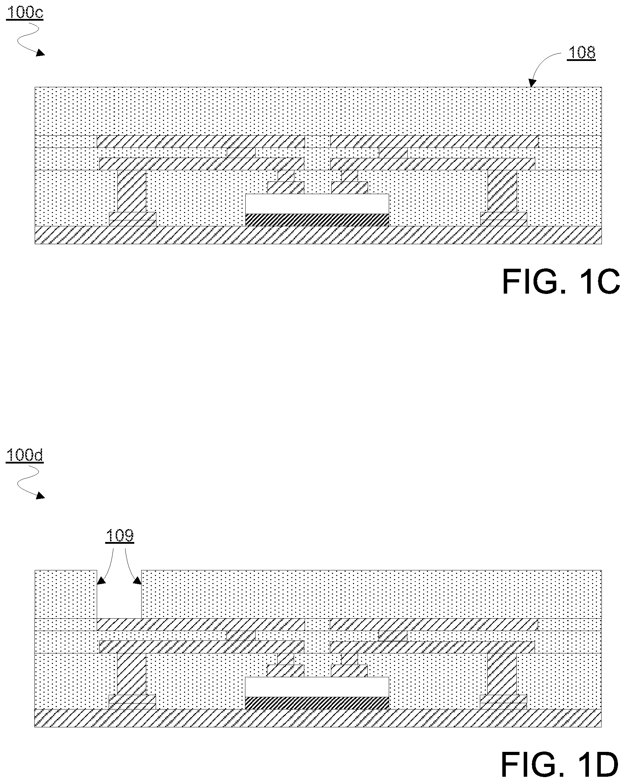

In an embodiment, a MEMS bottom electrode (not shown) may be formed in one of the build-up layers - e.g. by a sequence of electroless plating, dry film resist (DFR) patterning, electroplating, and flash etch processing. Such a MEMS bottom electrode may be provided for ultimate electrostatic actuation or capacitive sensing detection of a MEMS actuator/sensor structure to couple to such an electrode. Formation of one such BBUL MEMS structure 118 according to an illustrative embodiment is discussed hereafter with reference to FIGs. 1C-1H.

Referring to view 100c of FIG. 1C, a BBUL MEMS bottom sacrificial layer 108 may be defined - e.g. on a release etch stop layer lamination layer (e.g., low-E Ajinomoto Build-up Film or derivative thereof having a lower plasma etch rate than a standard ABF film) of the build-up layers. It is noted that only one side of the BBUL panel is shown for simplicity from FIG. 1C and on. As shown in view 100d of FIG. 1D, walls 109 may be formed to define in BBUL MEMS bottom sacrificial layer 108 a hole to position and/or provide a mechanical anchoring point for the MEMS actuator structure 118. Formation of the hole in BBUL MEMS bottom sacrificial layer 108 may be performed with a CO2 laser, an ultraviolet (UV) laser or the like - e.g. depending upon the thickness of BBUL MEMS bottom sacrificial layer 108.

Material of BBUL MEMS bottom sacrificial layer 108 may be subjected to a controlled swelling process - e.g. using an organic acid such as alkoxy-ethanol or any of various other alkaline based swellers. Such controlled swelling may lead to formation of a swelling zone on and/or through BBUL MEMS bottom sacrificial layer 108. Subsequent to such swelling, desmearing may be performed to prepare the surface of BBUL MEMS bottom sacrificial layer 108 at least in part for a material - e.g. a seed layer of copper or another metal - to be subsequently disposed thereon. For example, desmearing of BBUL MEMS bottom sacrificial layer 108 may include operations to variously form pockets or other such indentation structures in the desmeared surface. Alternatively or in addition, such desmearing may be performed at least in part to remove residue such as that generated by the laser drill operation which forms walls 109.

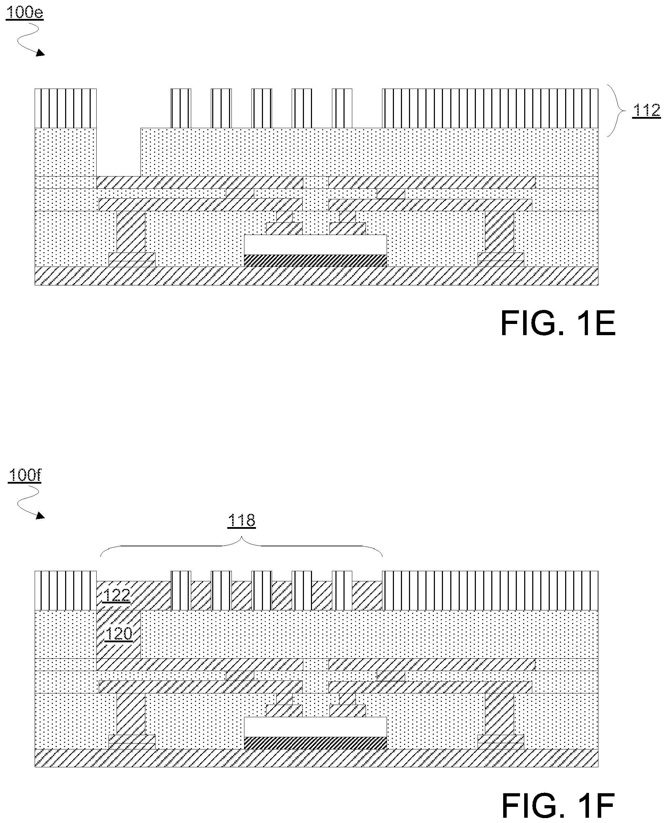

Subsequent to the swelling and desmear etching of BBUL MEMS bottom sacrificial layer 108, a BBUL MEMS structure 118 (e.g., including an anchor 120 and cantilever 122) is then fabricated. By way of illustration and not limitation, a patterned dry film resistor (DFR) layer 112 may be defined on the desmeared BBUL MEMS bottom sacrificial layer 108, as illustrated in view 100e of FIG. 1E. Subsequently, copper or another metal may be sputtered, plated and/or otherwise disposed through the pattern of DFR layer 112 to selectively exposed portions of BBUL MEMS bottom sacrificial layer 108. As shown in view 100f of FIG. 1F, the resulting BBUL MEMS structure 118 includes an anchor 120 and a cantilever 122 comprising structures which are to form a plurality of through-holes.

Referring now to view 100g of FIG. 1G, a BBUL MEMS top sacrificial layer 130 may be defined on BBUL MEMS bottom sacrificial layer 108 and MEMS structure 118 for a subsequent etch to release at least part of BBUL MEMS structure 118. For example, a patterned DRF layer 140 may be formed on BBUL MEMS top sacrificial layer 130, where patterned holes in DRF layer 140 allow for a subsequent controlled flash etch to remove portions of BBUL MEMS top sacrificial layer 130 and/or BBUL MEMS bottom sacrificial layer 108 which adjoin cantilever 122 and/or anchor 120. The presence of through-holes 150 in cantilever 122 facilitates an improved etching to expose and remove material between the underside of cantilever 122 and a proximate layer of the semiconductor package - e.g. a release etch stop layer lamination layer. The resulting removal may form an open gap 155 which separates the cantilever 122 from the underlying layer, resulting in at least a portion of cantilever 122 being suspended over the proximate layer.

In an embodiment, an active surface of semiconductor die 104 includes a plurality of semiconductor devices, such as but not limited to transistors, capacitors and resistors interconnected together by a die interconnection structure into functional circuits to thereby form an integrated circuit. As will be understood to those skilled in the art, the device side of the semiconductor die 104 may include an active portion with integrated circuitry and interconnections. The semiconductor die may be any appropriate integrated circuit device including but not limited to a microprocessor (single or multi-core), a memory device, a chipset, a graphics device, an application specific integrated circuit according to several different embodiments. In another embodiment, more than one die is embedded in the same package. For example, in one embodiment, a packaged semiconductor die further includes a secondary stacked die. The first die may have one or more through-silicon vias disposed therein (TSV die). The second die may be electrically coupled to the TSV die through the one or more through-silicon vias. In one embodiment, both dies are embedded in a coreless substrate.

The packaged semiconductor die 104 may, in an embodiment, be a fully embedded and surrounded semiconductor die. As used in this disclosure, "fully embedded and surrounded" means that all surfaces of the semiconductor die are in contact with an encapsulating film (such as a dielectric layer) of substrate, or at least in contact with a material housed within the encapsulating film. Said another way, "fully embedded and surrounded" means that all exposed surfaces of the semiconductor die are in contact with the encapsulating film of a substrate.

The packaged semiconductor die 104 may, in an embodiment, be a fully embedded semiconductor die. As used in this disclosure, "fully embedded" means that an active surface and the entire sidewalls of the semiconductor die are in contact with an encapsulating film (such as a dielectric layer) of a substrate, or at least in contact with a material housed within the encapsulating film. Said another way, "fully embedded" means that all exposed regions of an active surface and the exposed portions of the entire sidewalls of the semiconductor die are in contact with the encapsulating film of a substrate. However, in such cases, the semiconductor die may or may not be "surrounded" insofar as the backside of the semiconductor die is not in contact with an encapsulating film of the substrate or with a material housed within the encapsulating film. In a first embodiment, a back surface of the semiconductor die protrudes from the global planarity surface of the die side of a substrate. In a second embodiment, no surface of the semiconductor die protrudes from the global planarity surface of the die side of a substrate.

In contrast to the above definitions of "fully embedded and surrounded" and "fully embedded," a "partially embedded" die is a die having an entire surface, but only a portion of the sidewalls, in contact with an encapsulating film of a substrate (such as a coreless substrate), or at least in contact with a material housed within the encapsulating film. In further contrast, a "non-embedded" die is a die having at most one surface, and no portion of the sidewalls, in contact with an encapsulating film of a substrate (such as a coreless substrate), or in contact with a material housed within the encapsulating film.

In an embodiment, an array of external conductive contacts (not shown) may subsequently be formed. The external conductive contacts may couple the formed substrate to a foundation substrate. The external conductive contacts may be used for electrical communication with the foundation substrate. In one embodiment, the array of external conductive contacts is a ball grid array (BGA). In other embodiments, the array of external conductive contacts is an array such as, but not limited to, a land grid array (LGA) or an array of pins (PGA). In an embodiment, as described above, the substrate is a BBUL substrate. Although described in detail above for a BBUL process, other process flows may be used instead. For example, in another embodiment, die 104 is housed in a core of a substrate. In another embodiment, fan-out layers are used.

The term "MEMS" generally refers to an apparatus incorporating some mechanical structure having a dimensional scale that is comparable to microelectronic devices. The mechanical structure is typically capable of some form of mechanical motion and having dimensions below approximately 250 microns. However, in an embodiment, a MEMS on package structure has a total size exceeding approximately 1 mm, but has a beam width on an order of up to a few tens of microns. Thus, MEMS structures contemplated herein are, in an embodiment, any device that falls within the scope of MEMS technologies. For example, a MEMS structure may be any mechanical and electronic structure having a critical dimension of less than approximately 250 microns and fabricated using lithography, deposition, and etching processes above a substrate. In accordance with an embodiment of the present invention, the MEMS structure is a device such as, but not limited to, a resonator, a sensor, a detector, a filter or a mirror. In one embodiment, the MEMS structure is a resonator. In a specific embodiment, the resonator is one such as, but not limited to, a beam, a plate and a tuning fork or a cantilever arm.

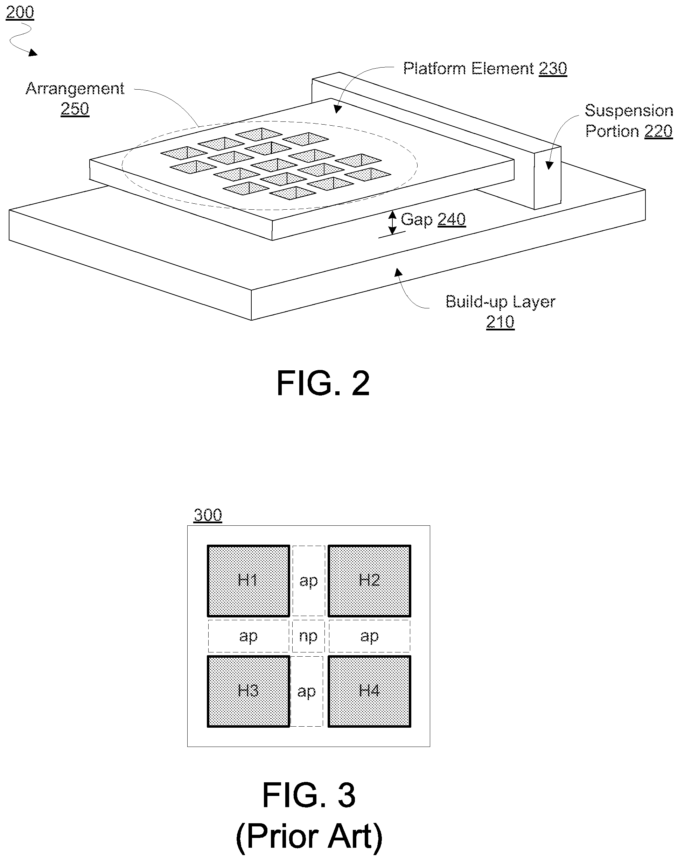

FIG. 2 illustrates elements of a semiconductor package 200 including through-holes according to an embodiment. Semiconductor package 200 may include some or all of the features of the semiconductor package formed by the process illustrated in FIGs. 1A-1H, for example. However, fabrication of semiconductor package 200 may be performed according to any of a variety of additional or alternative techniques, in different embodiments.

Semiconductor package 200 may include a plurality of build-up layers, represented in part by the illustrative build-up layer 210. By way of illustration and not limitation, semiconductor package 200 may form around a die (not shown) a plurality of alternating layers of patterned conductive material and insulating material - e.g. wherein at least one of the layers of patterned conductive material couples a MEMS device to a contact point of the die. The MEMS device may comprise a platform element 230 (also referred to herein as a beam element) which, for example, is to serve as a proof mass, cantilever, resonator or other active element. A portion of platform element 230 may be separated from (e.g. suspended over) build-up layer 210 by a gap 210. Such separation may be provided, for example, with a suspension portion 220 which provides at least one anchor point for platform element 230.

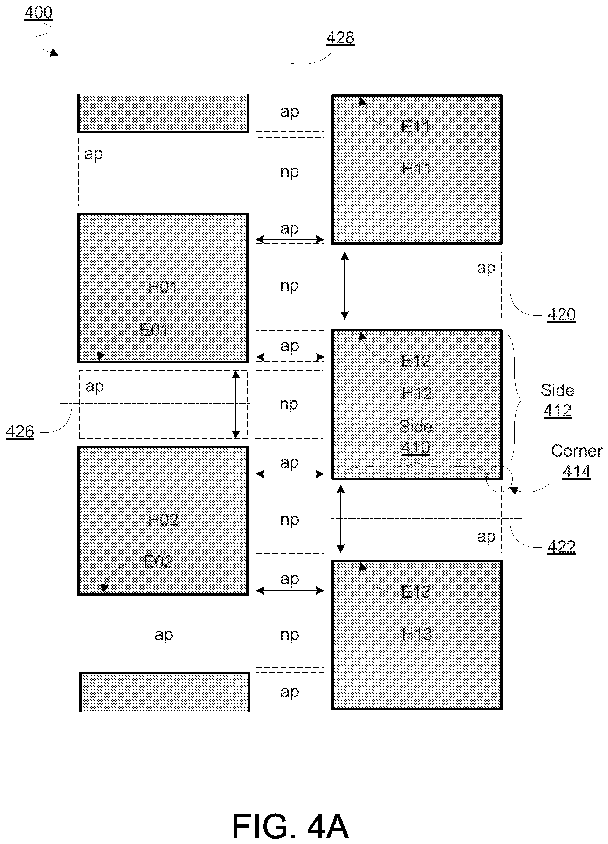

In an embodiment, a surface of platform element 230 includes an arrangement 250 of through-holes structures which define through-holes at least in part. As used herein, through-hole (also referred to herein as a "release hole" or, for brevity, simply "hole") refers to a hole which extends all of the way through a suspended portion of a structure - e.g. the structure including at least part of a beam, cantilever, proof mass, or other element of a MEMS device. Certain embodiments variously provide for an improved arrangement for through-hole structures in a MEMS device of a semiconductor package. Such improved arrangements may facilitate improved etching to form a gap which separates a suspended potion of the MEMS device from another structure proximate thereto. In turn, such improved etching may allow for through holes to be smaller in size and/or number, as compared to the size and/or number of through-hole structures arranged according to conventional techniques. For example, FIGs. 4A-4F illustrate various arrangements of through-hole structures according to different embodiments. Defined below are various terms used to discuss the geometry such arrangements.

Unless otherwise indicated herein, "surface" refers to either of two opposing surfaces of such a suspended portion of a MEMS device, where a plurality of through-holes variously extend between the two opposing surfaces. The surface may be a flat surface, although certain embodiments are not limited in this regard. Unless indicated otherwise, "edge" is used herein to refer to a portion of the surface which defines at least in part a corresponding through-hole. For example, a surface may include a plurality of edges each defining an intersection of that surface with a corresponding through-hole. By way of illustration and not limitation, arrangement 400 of FIG. 4A shows edges E01, E02, E11, E12, E13 which, respectively, define at least in part corresponding through-holes H01, H02, H11, H12, H13 of a plurality of through-holes.

Each of a plurality of edges may be self-enclosed and include a respective one or more continuous - e.g. straight or smooth curved - portions which are each referred to herein as a "side." An edge may have a single side which curves continuously back to itself to define in part a hole which has a circular, elliptical, oblong or other rounded profile within the side. Alternatively or in addition, an edge may include a plurality of straight edges which define in part a hole which has a polygonal profile within the side. Unless otherwise indicated, "corner" is used herein to refer to a portion of an edge which is at an angled junction of two sides of that edge. For example, the four sides of edge E12 include a side 410 and a side 412 which meet in the surface at a corner 414. Although certain embodiments are not limited in this regard, each of edges E01, E02, E11, E13 similarly includes respective straight edges and respective corners at various junctions of such straight edges.

The term "edge-adjacent" is used herein to describe relative proximity of edges to one another. A first edge and a second edge are considered to be edge-adjacent where the first edge includes one or more points of closest proximity to the second edge, and where - other than the first edge itself - the second edge (e.g. and not any other third edge) is the closest edge to those one or more points.

For a given first side of a first edge and a given second side of a second edge, the first side is considered herein to be "facing" the second side where at some point on the first side, a line normal to the first side could be drawn to extend away from the first edge and intersect the second side. Where a portion of a given side (for brevity, referred to herein as a "side portion") faces some other side of a different edge, another portion of that same given side may not face that other side of the different edge, and may not face that different edge at all.

In an embodiment, the surface may include what are referred to herein as "arm portions" and "node portions" which variously define at least in part a relative arrangement of through-hole structures with respect to one another. As used herein, "arm portion" (or simply "ap") refers to a portion of the surface which includes one or more points each located between a particular pair of edge-adjacent edges. An arm portion may include an area of minimal separation between two edge-adjacent edges. In an embodiment, an arm portion includes points of a surface through which at least one of two edge-adjacent edges faces the other of the two edge-adjacent edges. For example, an arm portion may include a point along a line through which each of the edge-adjacent edges face the other of the edge-adjacent edges. Alternatively or in addition, such an arm portion may include a point along a line through which only one of a pair of edge-adjacent edges face the other of that pair of edge-adjacent edges.

As used herein, a "node portion" (or simply "np") refers to a portion of the surface which is at a junction of a corresponding plurality of - e.g. three or more - arm portions. A junction of arm portions is understood herein to mean a location where such arm portions converge with or otherwise meet one another. For a given node portion, a corresponding set of edges may be positioned about the node portion, where any of a variety of combinations of one or more respective corners and/or side portions of the set of edges define the node portion at least in part.

Certain embodiments variously prevent or otherwise limit instances of a type of rectilinear arrangement of arm portions at a given node portion. FIG. 3 shows one example of such a conventional arrangement 300 which, for example, may be provided in silicon MEMS devices according to known techniques.

In arrangement 300, square holes H1, H2, H3, H4 are defined by respective edges which define a cruciform or otherwise orthogonal junction of exactly four arm portions. The arm portions of arrangement 300 are each parallel to and aligned with a respective opposite arm portion on the other side of the node. The square holes H1, H2, H3, H4, and their rectilinear arrangement with respect to one another, are comparatively easy to implement. However, certain embodiments are a result of a realization that such a rectilinear arrangement of holes H1, H2, H3, H4 is associated with particular inefficiency with respect to an etching of material underlying arrangement 300.

For example, of the edges which define the node portion shown in arrangement 300, only respective corners of those edges adjoin that node portion. Moreover, of the sides which define those corners, none of the sides faces toward the node portion. Consequently, a sacrificial material which under the node portion of arrangement 300 may have relatively limited exposure to etching - e.g. where such exposure is predominantly via the proximate corners of holes H1, H2, H3, H4 which define the node portion.

By contrast, arrangement 400 illustrates one example of plurality of edges arranged to limit or otherwise prevent instances of such cruciform configurations of arm portions. In arrangement 400, edges E01, E02, E11, E12, E13 in a surface define at least in part respective holes H01, H02, H11, H12, H13. For example, edges E01, E02, E11, E12, E13 may define for each of holes H01, H02, H11, H12, H13 a respective intersection of the hole with the surface. In the illustrative embodiment of arrangement 400, edges E01, E11 and E12 are each edge-adjacent to one another. Additionally or alternatively, edges E02, E12 and E13 may each be edge-adjacent to one another and/or edges E01, E02 may be edge-adjacent to one another. Accordingly, the surface shown in arrangement 400 may include different respective arm portions for each of the pairs E01/E11, E01/E12, E02/E12, E02/E13 and E01/E02 of edge-adjacent edges.

The surface shown in arrangement 400 may include a node portion at a junction of the arm portions which are each between a different respective pair of E01, E11 and E12. For example, E01, E11 and E12 may be positioned around and define at least in part a node portion which is at a junction of multiple arm portions, where a total number of the multiple arm portions is a number other than four (4) - in this case three (3). The surface shown in arrangement 400 include another node portion at a junction of the arm portions which are each between a different respective pair of E02, E12 and E13. The node portion defined at least in part by E02, E12 and E13 may located be a junction of another multiple arm portions, where a total number of the other multiple arm portions is also a number other than four (4).

As a result, some or all node portions of arrangement 400 are each of a type other than that which is associated with an orthogonal junction of exactly four arm portions. By way of illustration and not limitation, one or more arm portions of arrangement 400 may each be associated with a respective mid-line, as represented by the illustrative mid-lines 420, 422, 426, 428. Mid-lines 420, 422, 426 may variously extend each along a respective line of direction which intersects both an adjoining node portion and an edge which defines that node portion at least in part. Although one or more arm portions may be aligned with one another - e.g. where arm portions share a common mid-line 428 - the node portions of arrangement 400 may each adjoin at least one side portion (as opposed to adjoining merely corners) of edges which define that node portion.

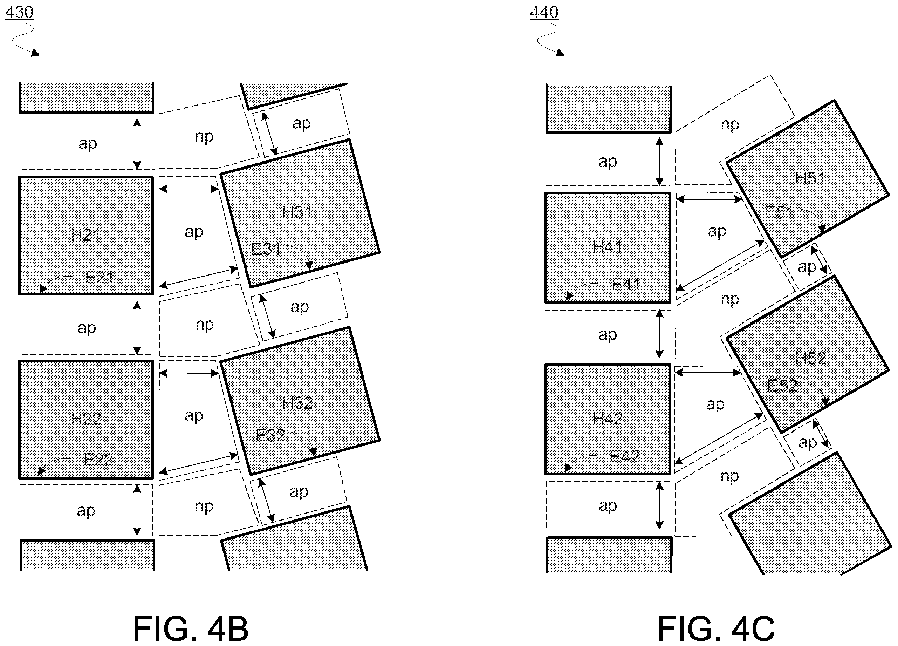

FIG. 4B illustrates features of another arrangement 430 of through hole-structures according to an embodiment of the invention. In arrangement 430, edges E21, E22, E31, E32 define at least in part corresponding through-holes H21, H22, H31, H32, respectively. In the illustrative embodiment of arrangement 430, edges E21 and E22 are edge-adjacent to one another. Additionally or alternatively, edges E21 and E31 may be edge-adjacent to one another and/or edges E22 and E32 may be edge-adjacent to one another. It is noted that while edges E32, E21 may be adjacent to one another, they may not include respective sides which face one another (e.g. at least insofar as their closest points of proximity to one another are respective corners for which a normal line cannot be drawn).

Accordingly, the surface shown in arrangement 430 may include different respective arm portions for each of the pairs E21/E22, E21/E31, E22/E32 and E31/E32 of edge-adjacent edges. A node portion may be located at a junction of such arm portions, wherein edges E21, E22, E31, E32 variously adjoin and are positioned around that node portion. In an embodiment, some or all of edges E21, E22, E31, E32 have different respective orientations - e.g. where sides of E21 and E31 extend along respective lines of direction which are oblique to one another. As a result, one or more side portions may adjoin the node portion, rather than mere corners of E21, E22, E31, E32. For example, a side portion of edge E32 and/or a side portion of E31 may adjoin the node portion, which allows material underlying such a node portion to be better exposed to etching, as compared to through-hole arrangements according to conventional techniques.

FIG. 4C illustrates features of another arrangement 440 of through hole-structures according to an embodiment of the invention. Arrangement 440 is similar in certain respects to arrangement 440, with one exception being a larger misalignment between adjacent rows of edges. In arrangement 440, edges E41, E42, E51, E52 define at least in part corresponding through-holes H41, H42, H51, H52, respectively. The surface shown in arrangement 440 may include different respective arm portions for each of the pairs E41/E42, E41/E51, E42/E52 and E51/E52 of edge-adjacent edges. A node portion may be located at a junction of such arm portions, wherein edges E41, E42, E51, E52 variously adjoin and are positioned around that node portion. In addition to the different orientations of the respective shapes defined by edges E41, E44, E51, E52, arrangement 440 provides a relatively large misalignment of rows of edges (e.g. where one such row includes edges E41, E42, and another such row includes edges E51, E52). As a result, side portions of E41, E42, E51, E52 may variously adjoin the node portion to a greater extent than side portions of edges E21, E22, E31, E32 adjoin their corresponding node portion.

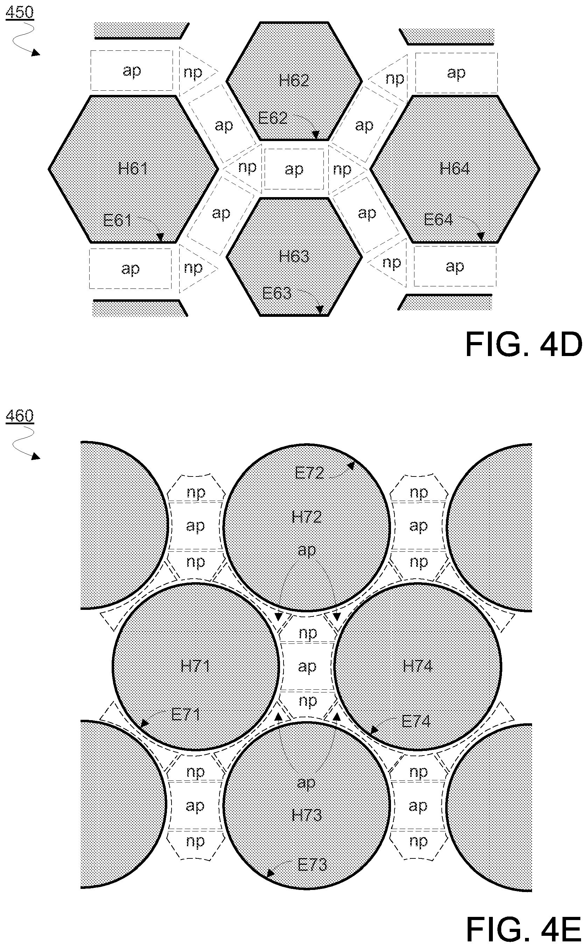

FIG. 4D illustrates features of another arrangement 450 of through hole-structures according to an embodiment. In arrangement 450, edges E61, E62, E63, E64 define at least in part corresponding through-holes H61, H62, H63, H64, respectively. Some or all of edges E61, E62, E63, E64 may variously define in the surface respective polygonal - e.g. hexagonal - shapes other than rectangular shapes. Such polygonal shapes may be arranged to define arm portions which meet at a node portion at oblique angles to one another. Alternatively or in addition, one or more such polygonal shapes may include obtuse corners which adjoin the node portion.

In the illustrative embodiment of arrangement 450, edges E61, E62 and E63 are each edge-adjacent to one another. Additionally or alternatively, edges E62, E63 and E64 may each be edge-adjacent to one another. Accordingly, the surface shown in arrangement 450 may include different respective arm portions for each of the pairs E61/E62, E62/E63, E61/E63, E62/E64 and E63/E64 of edge-adjacent edges. The surface shown in arrangement 450 may include a node portion at a junction of the arm portions which are each between a different respective pair of E61, E62 and E63. For example, E61, E62 and E63 may be positioned around and define at least in part a node portion which is at a junction of a total of three (3) arm portions. The surface shown in arrangement 450 include another node portion at a junction of the arm portions which are each between a different respective pair of E62, E63 and E64. The node portion defined at least in part by E62, E63 and E64 may located be a junction of another total of three (3) arm portions.

FIG. 4E illustrates features of another arrangement 460 of through hole-structures according to an embodiment. In arrangement 460, edges E71, E72, E73, E74 define at least in part corresponding through-holes H71, H72, H73, H74, respectively. Some or all of edges E71, E72, E73, E74 may variously define round - e.g. circular - shapes in the surface. Such round shapes may be arranged to define arm portions which meet at a node portion at oblique angles to one another. In the illustrative embodiment of arrangement 460, edges E71, E72 and E74 are each edge-adjacent to one another. Additionally or alternatively, edges E71, E73 and E74 may each be edge-adjacent to one another. Accordingly, the surface shown in arrangement 460 may include different respective arm portions for each of the pairs E71/E72, E72/E74, E71/E73, E73/E74 and E71/E74 of edge-adjacent edges. The surface shown in arrangement 460 may include a node portion at a junction of the arm portions which are each between a different respective pair of E71, E72 and E74. The surface shown in arrangement 460 include another node portion at a junction of the arm portions which are each between a different respective pair of E71, E73 and E74.

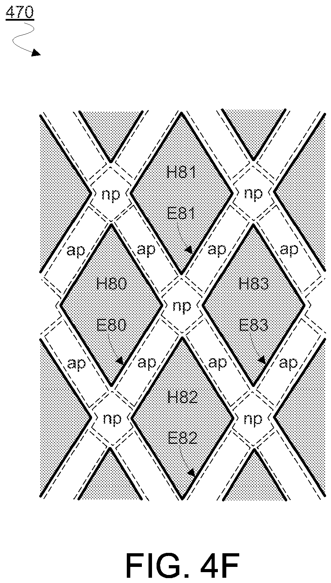

FIG. 4F illustrates features of another arrangement 470 of through hole-structures according to an embodiment. In arrangement 470, edges E80, E81, E82, E83 define at least in part corresponding through-holes H80, H81, H82, H83, respectively. Some or all of edges E80, E81, E82, E83 may variously define diamond shapes in the surface. Such diamond shapes may be arranged to define arm portions which meet at a node portion at oblique angles to one another. Alternatively or in addition, one or more such diamond shapes may include obtuse corners which adjoin the node portion.

In the illustrative embodiment of arrangement 470, edges E80, E81 and E83 are each edge-adjacent to one another. Additionally or alternatively, edges E80, E82 and E83 may each be edge-adjacent to one another. Accordingly, the surface shown in arrangement 470 may include different respective arm portions for each of the pairs E80/E81, E81/E83, E80/E82 and E82/E83 of edge-adjacent edges. The surface shown in arrangement 470 may include a node portion at a junction of the arm portions which are each between a different respective pair of E80, E81 E82 and E83.

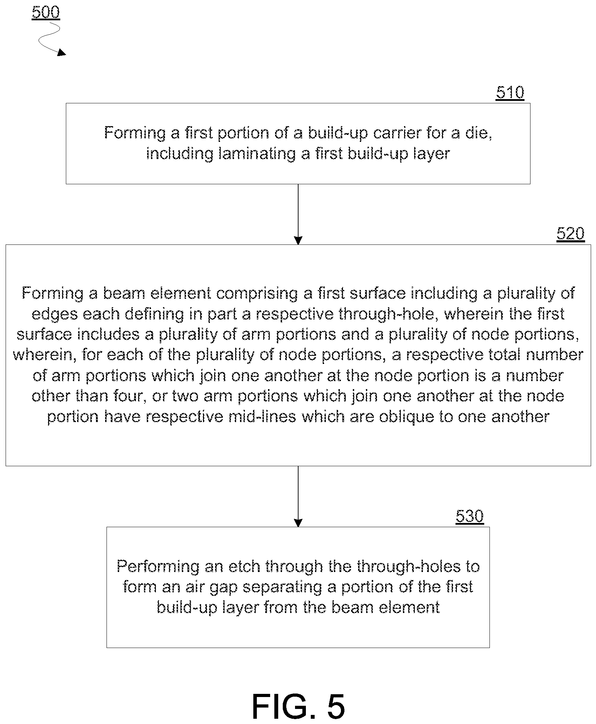

FIG. 5 illustrates elements of a method 500 for fabricating a semiconductor package according to an embodiment. The semiconductor package may include an arrangement of through-hole structures comprising some or all of the features of any of arrangements 250, 400, 430, 440, 450, 460, 470, for example. In an embodiment, method 500 performs some or all of the operations represented in FIGs. 1A-1H.

Method 500 may include, at 510, forming a first portion of a build-up carrier for a die, including laminating a first build-up layer. The first build-up layer may include a release etch stop layer lamination layer including, but not limited to, any of a variety of low-E Ajinomoto Build-up Films or equivalents thereof. In an embodiment, method 500 further comprises, at 520, forming a beam element comprising a first surface including a plurality of edges each defining in part a respective through-hole, wherein the first surface includes a plurality of arm portions and a plurality of node portions each located at a respective junction of three or more of the plurality of arm portions.

The plurality of arm portions may each be located between a respective pair of edge-adjacent edges of the plurality of edges. For each of the node portions, a respective total number of arm portions which join one another at the node portion is a number other than four, or two arm portions which join one another at the node portion have respective mid-lines which are oblique to one another. In an embodiment, for each of the plurality of node portions, if the node portion is located at a junction of a respective first, second, third and fourth arm portions, where respective mid-lines of the first arm portion and the second arm-portion are parallel to one another, and where respective mid-lines of the third arm portion and the fourth arm-portion are parallel to one another, then the respective mid-lines of the first arm portion and the third arm portion are oblique to one another (and/or respective mid-lines of the second arm portion and the fourth arm portion are oblique to one another).

The plurality of edges may include an edge which defines a round shape - e.g. a circle or an ellipse - in the first surface. Alternatively or in addition, the plurality of edges may include an edge which defines a polygonal shape in the first surface - e.g. a triangle, pentagon, hexagon, octagon or the like - a wherein a total number of sides of the polygonal shape is a number other than four. Alternatively or in addition, the plurality of edges may include an edge which defines a diamond shape (e.g. a parallelogram other than a rectangle) in the first surface.

In an embodiment, the plurality of edges include a first row of rectangular edges and a second row of rectangular edges each extending along a first line of direction, wherein, for each of the first row of rectangular edges and the second row of rectangular edges, one or more edges of the row each include a respective straight side which extends along the first line of direction. In such an embodiment, an edge of the first row and an edge of the second row may include corresponding sides which are parallel to one another and offset from one another along the first line of direction by a distance which, for example, is less than a length of one of the edges along that first line of direction. Such an arrangement is illustrated, for example, in FIG. 4A.

In another embodiment, the plurality of edges include a first row of rectangular edges and a second row of rectangular edges each extending along a first line of direction, wherein one or more edges of the first row of rectangular edges each include a respective side which extends along a second line of direction which is oblique to the first line of direction. In an embodiment, the plurality of node portions includes a first node portion at a junction of only three of the plurality of arm portions. Alternatively or in addition, the plurality of node portions may include a node portion which is at a junction of five or more arm portions.

Method 530 may include, at 530, performing an etch through the plurality of through-holes (e.g. at least in part) to form an air gap separating a portion of the first build-up layer from the beam element. The etch performed at 430 may include a controlled flash etch, for example. In an embodiment, the etching removes another portion of the first build-up layer to expose the portion of the first build-up layer which is separated from the beam element by the air gap.

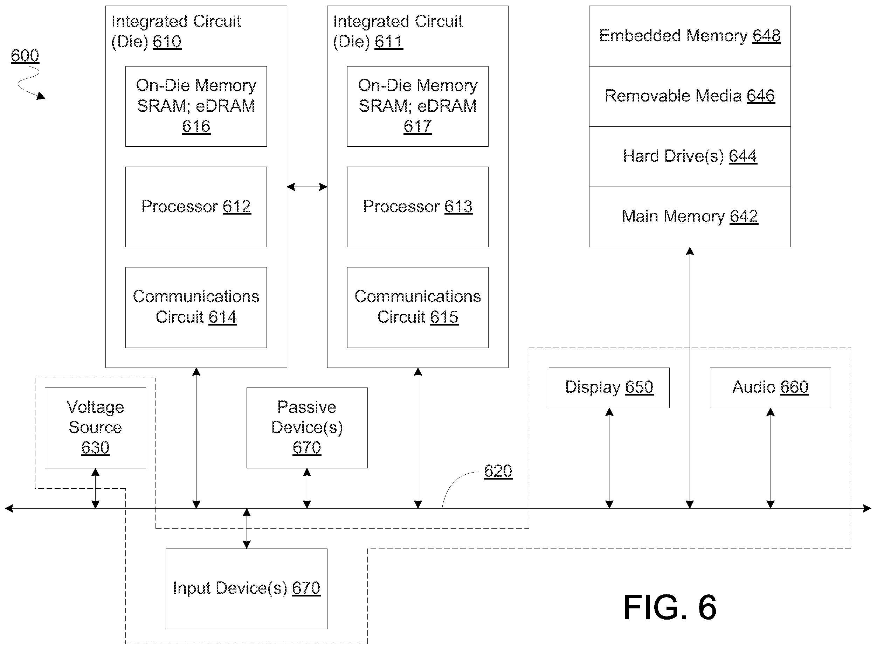

FIG. 6 is a schematic of a computer system 600, in accordance with an illustrative example. The computer system 600 (also referred to as the electronic system 600) as depicted can embody a semiconductor package having a mechanical fuse therein according to any of the several disclosed embodiments and their equivalents as set forth in this disclosure. The computer system 600 may be a mobile device such as a netbook computer. The computer system 600 may be a mobile device such as a wireless smart phone. The computer system 600 may be a desktop computer. The computer system 600 may be a hand-held reader.

In an embodiment, the electronic system 600 is a computer system that includes a system bus 620 to electrically couple the various components of the electronic system 600. The system bus 620 is a single bus or any combination of busses according to various embodiments. The electronic system 600 includes a voltage source 630 that provides power to the integrated circuit 610. In some embodiments, the voltage source 630 supplies current to the integrated circuit 610 through the system bus 620.

The integrated circuit 610 is electrically coupled to the system bus 620 and includes any circuit, or combination of circuits according to an embodiment. In an embodiment, the integrated circuit 610 includes a processor 612 that can be of any type. As used herein, the processor 612 may mean any type of circuit such as, but not limited to, a microprocessor, a microcontroller, a graphics processor, a digital signal processor, or another processor. In an embodiment, the processor 612 includes or is included in a semiconductor package having a mechanical fuse therein, as disclosed herein. In an embodiment, SRAM embodiments are found in memory caches of the processor. Other types of circuits that can be included in the integrated circuit 610 are a custom circuit or an application-specific integrated circuit (ASIC), such as a communications circuit 614 for use in wireless devices such as cellular telephones, smart phones, pagers, portable computers, two-way radios, and similar electronic systems. In an embodiment, the processor 610 includes on-die memory 616 such as static random-access memory (SRAM). In an embodiment, the processor 610 includes embedded on-die memory 616 such as embedded dynamic random-access memory (eDRAM).

In an embodiment, the integrated circuit 610 is complemented with a subsequent integrated circuit 611. Useful embodiments include a dual processor 613 and a dual communications circuit 615 and dual on-die memory 617 such as SRAM. In an embodiment, the dual integrated circuit 610 includes embedded on-die memory 617 such as eDRAM.

In an embodiment, the electronic system 600 also includes an external memory 640 that in turn may include one or more memory elements suitable to the particular application, such as a main memory 642 in the form of RAM, one or more hard drives 644, and/or one or more drives that handle removable media 646, such as diskettes, compact disks (CDs), digital variable disks (DVDs), flash memory drives, and other removable media known in the art. The external memory 640 may also be embedded memory 648 such as the first die in an embedded TSV die stack, according to an embodiment.

In an embodiment, the electronic system 600 also includes a display device 650 and an audio output 660. In an embodiment, the electronic system 600 includes an input device such as a controller 670 that may be a keyboard, mouse, trackball, game controller, microphone, voice-recognition device, or any other input device that inputs information into the electronic system 600. In an embodiment, an input device 670 is a camera. In an embodiment, an input device 670 is a digital sound recorder. In an embodiment, an input device 670 is a camera and a digital sound recorder.

As shown herein, the integrated circuit 610 may be implemented in a number of different embodiments, including a semiconductor package having a mechanical fuse therein according to any of the several disclosed embodiments and their equivalents, an electronic system, a computer system, one or more methods of fabricating an integrated circuit, and one or more methods of fabricating an electronic assembly that includes a semiconductor package having a mechanical fuse therein according to any of the several disclosed embodiments as set forth herein in the various embodiments and their art-recognized equivalents. The elements, materials, geometries, dimensions, and sequence of operations can all be varied to suit particular I/O coupling requirements including array contact count, array contact configuration for a microelectronic die embedded in a processor mounting substrate according to any of the several disclosed semiconductor package having a mechanical fuse therein embodiments and their equivalents. A foundation substrate may be included, as represented by the dashed line of FIG. 6. Passive devices may also be included, as is also depicted in FIG. 6.

In one implementation, a semiconductor package comprises a build-up carrier coupled to a die, the build-up carrier comprising a first build-up layer, and a beam element separated from a portion of the first build-up layer by an air gap. The beam element comprises a first surface and a second surface, the first surface including a plurality of edges each to define in part a respective through-hole of a plurality of through-holes which extend between the first surface and the second surface. The first surface includes a plurality of arm portions each located between a respective pair of edge-adjacent edges of the plurality of edges, and a plurality of node portions each located at a respective junction of three or more of the plurality of arm portions, wherein, for each of the node portions, a respective total number of arm portions which join one another at the node portion is a number other than four, or two arm portions which join one another at the node portion have respective mid-lines which are oblique to one another.

In an embodiment, for each of the plurality of node portions which is located at a junction of a respective first arm portion, second arm portion, third arm portion and fourth arm portion, where respective mid-lines of the first arm portion and the second arm-portion are parallel to one another, and where respective mid-lines of the third arm portion and the fourth arm-portion are parallel to one another, the respective mid-lines of the first arm portion and the third arm portion are oblique to one another. In another embodiment, the plurality of edges include a first row of rectangular edges and a second row of rectangular edges each extending along a first line of direction, wherein, for each of the first row of rectangular edges and the second row of rectangular edges, one or more edges of the row each include a respective side which extends along the first line of direction. In another embodiment, the plurality of edges include a first row of rectangular edges and a second row of rectangular edges each extending along a first line of direction, wherein one or more edges of the first row of rectangular edges each include a respective side which extends along a second line of direction which is oblique to the first line of direction.

In another embodiment, a first node portion of the plurality of node portions is at a junction of only three arm portions. In another embodiment, a first node portion of the plurality of node portions is at a junction of five or more arm portions. In another embodiment, the plurality of edges include an edge which defines a round shape in the first surface. In another embodiment, the round shape includes a circle. In another embodiment, the plurality of edges include an edge which defines a triangular shape in the first surface. In another embodiment, the plurality of edges include an edge which defines a polygonal shape in the first surface, wherein a total number of sides of the polygonal shape is greater than four. In another embodiment, the plurality of edges include an edge which defines a diamond shape in the first surface. In another embodiment, the through-holes are a set of hole-contiguous through-holes.

In one implementation, a method comprises forming a first portion of a build-up carrier for a die, including laminating a first build-up layer, and forming a beam element comprising a first surface and a second surface, the first surface including a plurality of edges each defining in part a respective through-hole of a plurality of through-holes extending between the first surface and the second surface. The first surface includes a plurality of arm portions each located between a respective pair of edge-adjacent edges of the plurality of edges, and a plurality of node portions each located at a respective junction of three or more of the plurality of arm portions, wherein, for each of the node portions, a respective total number of arm portions which join one another at the node portion is a number other than four, or two arm portions which join one another at the node portion have respective mid-lines which are oblique to one another. The method further comprises performing an etch through the plurality of through-holes to form an air gap separating a portion of the first build-up layer from the beam element.

In an embodiment, for each of the plurality of node portions which is located at a junction of a respective first arm portion, second arm portion, third arm portion and fourth arm portion, where respective mid-lines of the first arm portion and the second arm-portion are parallel to one another, and where respective mid-lines of the third arm portion and the fourth arm-portion are parallel to one another, the respective mid-lines of the first arm portion and the third arm portion are oblique to one another. In another embodiment, the plurality of edges include a first row of rectangular edges and a second row of rectangular edges each extending along a first line of direction, wherein, for each of the first row of rectangular edges and the second row of rectangular edges, one or more edges of the row each include a respective side which extends along the first line of direction. In another embodiment, the plurality of edges include a first row of rectangular edges and a second row of rectangular edges each extending along a first line of direction, wherein one or more edges of the first row of rectangular edges each include a respective side which extends along a second line of direction which is oblique to the first line of direction.

In another embodiment, a first node portion of the plurality of node portions is at a junction of only three arm portions. In another embodiment, a first node portion of the plurality of node portions is at a junction of five or more arm portions. In another embodiment, the plurality of edges include an edge which defines a round shape in the first surface. In another embodiment, the round shape includes a circle. In another embodiment, the plurality of edges include an edge which defines a triangular shape in the first surface. In another embodiment, the plurality of edges include an edge which defines a polygonal shape in the first surface, wherein a total number of sides of the polygonal shape is greater than four. In another embodiment, the plurality of edges include an edge which defines a diamond shape in the first surface. In another embodiment, the through-holes are a set of hole-contiguous through-holes.

In one implementation, a system comprises a computing device including a package including a micro-processor disposed in a build-up carrier, the build-up carrier comprising a first build-up layer, and a beam element separated from a portion of the first build-up layer by an air gap. The beam element comprises a first surface and a second surface, the first surface including a plurality of edges each to define in part a respective through-hole of a plurality of through-holes which extend between the first surface and the second surface. The first surface includes a plurality of arm portions each located between a respective pair of edge-adjacent edges of the plurality of edges, and a plurality of node portions each located at a respective junction of three or more of the plurality of arm portions, wherein, for each of the node portions, a respective total number of arm portions which join one another at the node portion is a number other than four, or two arm portions which join one another at the node portion have respective mid-lines which are oblique to one another.

In an embodiment, for each of the plurality of node portions, if the node portion is located at a junction of a respective first arm portion, second arm portion, third arm portion and fourth arm portion, where respective mid-lines of the first arm portion and the second arm-portion are parallel to one another, and where respective mid-lines of the third arm portion and the fourth arm-portion are parallel to one another, then the respective mid-lines of the first arm portion and the third arm portion are oblique to one another. In another embodiment, the plurality of edges include a first row of rectangular edges and a second row of rectangular edges each extending along a first line of direction, wherein, for each of the first row of rectangular edges and the second row of rectangular edges, one or more edges of the row each include a respective side which extends along the first line of direction. In another embodiment, the plurality of edges include a first row of rectangular edges and a second row of rectangular edges each extending along a first line of direction, wherein one or more edges of the first row of rectangular edges each include a respective side which extends along a second line of direction which is oblique to the first line of direction.

In another embodiment, a first node portion of the plurality of node portions is at a junction of only three arm portions. In another embodiment, a first node portion of the plurality of node portions is at a junction of five or more arm portions. In another embodiment, the plurality of edges include an edge which defines a round shape in the first surface. In another embodiment, the round shape includes a circle. In another embodiment, the plurality of edges include an edge which defines a triangular shape in the first surface. In another embodiment, the plurality of edges include an edge which defines a polygonal shape in the first surface, wherein a total number of sides of the polygonal shape is greater than four. In another embodiment, the plurality of edges include an edge which defines a diamond shape in the first surface. In another embodiment, the through-holes are a set of hole-contiguous through-holes.

Techniques and architectures for providing a semiconductor package are described herein. In the above description, for purposes of explanation, numerous specific details are set forth in order to provide a thorough understanding of certain embodiments. It will be apparent, however, to one skilled in the art that certain embodiments can be practiced without these specific details. In other instances, structures and devices are shown in block diagram form in order to avoid obscuring the description.

Some portions of the detailed description herein are presented in terms of algorithms and symbolic representations of operations on data bits within a computer memory. These algorithmic descriptions and representations are the means used by those skilled in the computing arts to most effectively convey the substance of their work to others skilled in the art. An algorithm is here, and generally, conceived to be a self-consistent sequence of steps leading to a desired result. The steps are those requiring physical manipulations of physical quantities. Usually, though not necessarily, these quantities take the form of electrical or magnetic signals capable of being stored, transferred, combined, compared, and otherwise manipulated. It has proven convenient at times, principally for reasons of common usage, to refer to these signals as bits, values, elements, symbols, characters, terms, numbers, or the like.

It should be borne in mind, however, that all of these and similar terms are to be associated with the appropriate physical quantities and are merely convenient labels applied to these quantities. Unless specifically stated otherwise as apparent from the discussion herein, it is appreciated that throughout the description, discussions utilizing terms such as "processing" or "computing" or "calculating" or "determining" or "displaying" or the like, refer to the action and processes of a computer system, or similar electronic computing device, that manipulates and transforms data represented as physical (electronic) quantities within the computer system's registers and memories into other data similarly represented as physical quantities within the computer system memories or registers or other such information storage, transmission or display devices.

Certain embodiments also relate to apparatus for performing the operations herein. This apparatus may be specially constructed for the required purposes, or it may comprise a general purpose computer selectively activated or reconfigured by a computer program stored in the computer. Such a computer program may be stored in a computer readable storage medium, such as, but is not limited to, any type of disk including floppy disks, optical disks, CD-ROMs, and magnetic-optical disks, read-only memories (ROMs), random access memories (RAMs) such as dynamic RAM (DRAM), EPROMs, EEPROMs, magnetic or optical cards, or any type of media suitable for storing electronic instructions, and coupled to a computer system bus.

The algorithms and displays presented herein are not inherently related to any particular computer or other apparatus. Various general purpose systems may be used with programs in accordance with the teachings herein, or it may prove convenient to construct more specialized apparatus to perform the required method steps. The required structure for a variety of these systems will appear from the description herein. In addition, certain embodiments are not described with reference to any particular programming language. It will be appreciated that a variety of programming languages may be used to implement the teachings of such embodiments as described herein.

Besides what is described herein, various modifications may be made to the disclosed embodiments and implementations thereof without departing from their scope. Therefore, the illustrations and examples herein should be construed in an illustrative, and not a restrictive sense. The scope of the invention should be measured solely by reference to the claims that follow.

## Claims

1. A semiconductor package (200) comprising:
a build-up carrier coupled to a die, the build-up carrier comprising a first build-up layer (210); and
a beam element (230) separated from a portion of the first build-up layer by an air gap (240), the beam element comprising a first surface and a second surface, the first surface including a plurality of edges each to define in part a respective through-hole of a plurality of through-holes which extend between the first surface and the second surface, wherein the first surface includes:
a plurality of arm portions (ap) each located between a respective pair of edge-adjacent edges of the plurality of edges; and
a plurality of node portions (np), wherein, for each of the node portions, two arm portions which join one another at the node portion have respective mid-lines which are oblique to one another;
**characterised in that** the plurality of through-holes includes a first plurality of rectangular through-holes arranged in a first row along a first straight line, and a second plurality of rectangular through-holes arranged in a second row along a second straight line parallel to the first straight line, the first row adjacent to the second row, wherein sides of the edges of the first plurality of rectangular through holes and sides of the edges of the second plurality of rectangular through holes extend along respective lines of direction which are oblique to one another.

2. A method comprising:
forming (510) a first portion of a build-up carrier for a die, including laminating a first build-up layer;
forming (520) on said first build-up layer a beam element comprising a first surface and a second surface, the first surface including a plurality of edges each defining in part a respective through-hole of a plurality of through-holes extending between the first surface and the second surface, wherein the first surface includes:
a plurality of arm portions each located between a respective pair of edge-adjacent edges of the plurality of edges; and
a plurality of node portions, wherein, for each of the node portions, two arm portions which join one another at the node portion have respective mid-lines which are oblique to one another;
Performing (530) an etch through the plurality of through-holes to remove a portion of said first build-up layer so as to form an air gap separating a portion of the first build-up layer from the beam element;
**characterised in that** the plurality of through-holes includes a first plurality of rectangular through-holes arranged in a first row along a first straight line, and a second plurality of rectangular through-holes arranged in a second row along a second straight line parallel to the first straight line, the first row adjacent to the second row, wherein sides of the edges of the first plurality of rectangular through holes and sides of the edges of the second plurality of rectangular through holes extend along respective lines of direction which are oblique to one another.

3. A system comprising:
a computing device including the package of claim 1 including a micro-processor disposed in the build-up carrier.

## Patentansprüche

1. Halbleiterpaket (200), Folgendes umfassend:
eine Aufbauhalterung, die an einen Stempel gekoppelt ist, wobei die Aufbauhalterung eine erste Aufbauschicht (210) umfasst; und
ein Trägerelement (230), das von einem Abschnitt der ersten Aufbauschicht durch einen Luftzwischenraum (240) getrennt ist, wobei das Trägerelement eine erste Fläche und eine zweite Fläche aufweist, wobei die erste Fläche mehrere Kanten enthält, die jeweils teilweise ein entsprechendes Durchgangsloch mehrerer Durchgangslöcher definieren, die sich zwischen der ersten Fläche und der zweiten Fläche erstrecken, wobei die erste Fläche Folgendes enthält:
mehrere Armabschnitte (ap), die jeweils zwischen einem jeweiligen Paar kantennaher Kanten der mehreren Kanten angeordnet sind; und
mehrere Knotenabschnitte (np), wobei für jeden Knotenabschnitt zwei Armabschnitte, die am Knotenabschnitt miteinander verbunden sind, entsprechende Mittellinien aufweisen, die schräg zueinander verlaufen;
**dadurch gekennzeichnet, dass**
die mehreren Durchgangslöcher erste mehrere rechteckige Durchgangslöcher, die in einer ersten Reihe entlang einer ersten Geraden angeordnet sind, und zweite mehrere rechteckige Durchgangslöcher enthalten, die in einer zweiten Reihe entlang einer zweiten Geraden parallel zu der ersten Geraden angeordnet sind, wobei die erste Reihe an die zweite Reihe angrenzt, wobei sich die Seiten der Kanten der ersten mehreren rechteckigen Durchgangslöcher und die Seiten der Kanten der zweiten mehreren rechteckigen Durchgangslöcher entlang entsprechender Richtungslinien erstrecken, die schräg zueinander verlaufen.

2. Verfahren, Folgendes umfassend:
Ausbilden (510) eines ersten Abschnitts einer Aufbauhalterung für einen Stempel, einschließlich Laminieren einer ersten Aufbauschicht;
Ausbilden (520) eines Trägerelements auf der ersten Aufbauschicht, das eine erste Fläche und eine zweite Fläche umfasst, wobei die erste Fläche mehrere Kanten enthält, die jeweils teilweise ein entsprechendes Durchgangsloch mehrerer Durchgangslöcher definieren, die sich zwischen der ersten Fläche und der zweiten Fläche erstrecken, wobei die erste Fläche Folgendes enthält:
mehrere Armabschnitte, die jeweils zwischen einem jeweiligen Paar kantennaher Kanten der mehreren Kanten angeordnet sind; und
mehrere Knotenabschnitte, wobei für jeden Knotenabschnitt zwei Armabschnitte, die am Knotenabschnitt miteinander verbunden sind, entsprechende Mittellinien aufweisen, die schräg zueinander verlaufen;
Durchführen (530) einer Ätzung durch die mehreren Durchgangslöcher, um einen Abschnitt der ersten Aufbauschicht zu entfernen, um einen Luftzwischenraum auszubilden, der einen Abschnitt der ersten Aufbauschicht von dem Trägerelement trennt;
**dadurch gekennzeichnet, dass**
die mehreren Durchgangslöcher erste mehrere rechteckige Durchgangslöcher, die in einer ersten Reihe entlang einer ersten Geraden angeordnet sind, und zweite mehrere rechteckige Durchgangslöcher enthalten, die in einer zweiten Reihe entlang einer zweiten Geraden parallel zu der ersten Geraden angeordnet sind, wobei die erste Reihe an die zweite Reihe angrenzt, wobei sich die Seiten der Kanten der ersten mehreren rechteckigen Durchgangslöcher und die Seiten der Kanten der zweiten mehreren rechteckigen Durchgangslöcher entlang entsprechender Richtungslinien erstrecken, die schräg zueinander verlaufen.

3. System, Folgendes umfassend:
eine Rechenvorrichtung einschließlich des Pakets aus Anspruch 1, einschließlich eines Mikroprozessors, der in der Aufbauhalterung angeordnet ist.

## Revendications

1. Boîtier de semi-conducteur (200) comprenant :
un support d'accumulation couplé à une matrice, le support d'accumulation comprenant une première couche d'accumulation (210) ; et
un élément de plaquette (230) séparé d'une partie de la première couche d'accumulation par un entrefer (240), l'élément de plaquette comprenant une première surface et une seconde surface, la première surface comprenant une pluralité de bords, chacun pour définir en partie un trou traversant respectif parmi une pluralité de trous traversants qui s'étendent entre la première surface et la seconde surface, la première surface comprenant :
une pluralité de parties de bras (ap) situées chacune entre une paire respective de bords adjacents à un bord parmi la pluralité de bords ; et
une pluralité de parties de noeud (np), pour chacune des parties de noeud, deux parties de bras qui se joignent l'une à l'autre au niveau de la partie de noeud ayant des lignes médianes respectives qui sont obliques l'une par rapport à l'autre ;
**caractérisé en ce que**
la pluralité de trous traversants comprend une première pluralité de trous traversants rectangulaires agencés dans une première rangée le long d'une première ligne droite, et une seconde pluralité de trous traversants rectangulaires agencés dans une seconde rangée le long d'une seconde ligne droite parallèle à la première ligne droite, la première rangée étant adjacente à la seconde rangée, les côtés des bords de la première pluralité de trous traversants rectangulaires et les côtés des bords de la seconde pluralité de trous traversants rectangulaires s'étendant le long de lignes de direction respectives qui sont obliques l'une par rapport à l'autre.

2. Procédé comprenant :
la formation (510) d'une première partie d'un support d'accumulation pour une matrice, comprenant la stratification d'une première couche d'accumulation ;
la formation (520) sur ladite première couche d'accumulation d'un élément de plaquette comprenant une première surface et une seconde surface, la première surface comprenant une pluralité de bords, définissant chacun en partie un trou traversant respectif parmi une pluralité de trous traversants s'étendant entre la première surface et la seconde surface, la première surface comprenant :
une pluralité de parties de bras situées chacune entre une paire respective de bords adjacents à un bord parmi la pluralité de bords ; et
une pluralité de parties de noeud, pour chacune des parties de noeud, deux parties de bras qui se joignent l'une à l'autre au niveau de la partie de noeud ayant des lignes médianes respectives qui sont obliques l'une par rapport à l'autre ;
la réalisation (530) d'une gravure à travers la pluralité de trous traversants pour enlever une partie de ladite première couche d'accumulation de manière à former un entrefer séparant une partie de la première couche d'accumulation de l'élément de plaquette ;
**caractérisé en ce que**
la pluralité de trous traversants comprend une première pluralité de trous traversants rectangulaires agencés dans une première rangée le long d'une première ligne droite, et une seconde pluralité de trous traversants rectangulaires agencés dans une seconde rangée le long d'une seconde ligne droite parallèle à la première ligne droite, la première rangée étant adjacente à la seconde rangée, les côtés des bords de la première pluralité de trous traversants rectangulaires et les côtés des bords de la seconde pluralité de trous traversants rectangulaires s'étendant le long de lignes de direction respectives qui sont obliques l'une par rapport à l'autre.

3. Système comprenant :
un dispositif informatique comprenant le boîtier selon la revendication 1, comprenant un microprocesseur disposé dans le support d'accumulation.
